# EUROPEAN PATENT APPLICATION

(11) **EP 4 729 344 A1**
(43) Date of publication of application: **22.04.2026**
(21) Application number: 25210103.5
(22) Date of filing: 21.10.2025
(51) Int. Cl.: B60L 53/302, B60L 53/31, F28D 1/02, F28D 1/04

(54) **COOLING SYSTEM AND CHARGING SYSTEM**

(30) Priority: 21.10.2024 CN 202422542675 U
(71) Applicant: ABB E-mobility B.V., 2629 JG Delft (NL)
(72) Inventor: TAN, Bing, Shenzhen, 518000 (CN); ZHENG, GanXing, Shenzhen, 518129 (CN); ZHANG, Leilei, Shenzhen, 518000 (CN); LING, Hongru, Shenzhen, 518000 (CN); YANG, YuQi, Shenzhen, 518101 (CN)
(74) Representative: Zimmermann & Partner Patentanwälte mbB

(57) **Abstract**

The present disclosure relates to a cooling system and a charging pile. The cooling system (100) comprises: at least one fan (110) configured to draw airflow from the radial outside during operation and discharge the drawn airflow in the axial direction; and at least one radiator (120), each radiator (120) being disposed to circumferentially surround a corresponding fan (110) of the at least one fan (110), wherein the radiator (120) at least includes a curved section (125) that at least partially follows the contour of the corresponding fan (110); wherein the radiator (120) comprises a plurality of radiator fins (122) arranged in a stacked manner relative to one another along the axial direction, and a gap (121) is formed between at least one pair of adjacent radiator fins (122) in the height direction perpendicular to the circumferential direction and the axial direction, the gap (121) allowing airflow to flow from the circumferential outside of the radiator (120) toward the circumferential inside of the radiator (120).

## Description

### Technical Field

The present disclosure relates to a charging pile, and more particularly to a cooling system for a charging pile.

### Background Art

Due to environmental advantages, electric vehicles are increasingly widely used in daily life. Electric vehicles use rechargeable batteries as power devices. During the use of electric vehicles, they require frequent charging. The charging of electric vehicles is implemented by charging piles.

Charging piles include power devices to convert alternating current to direct current. During the operation of charging piles, these power devices generate a large amount of heat. Therefore, charging piles are also equipped with cooling systems to dissipate heat for these power devices. Traditional heat dissipation systems are not satisfactory in terms of heat dissipation efficiency, and there is a desire to further improve the performance of heat dissipation systems.

### Summary

The purpose of the present disclosure is to provide a cooling system and a charging pile, aiming to solve one or more of the aforementioned problems and other potential problems.

A first aspect of the present disclosure provides a cooling system. The cooling system comprises: at least one fan configured to draw airflow from a radial outside during operation and discharge the drawn airflow in an axial direction; and at least one radiator, each radiator being disposed to circumferentially surround a corresponding fan of the at least one fan, wherein the radiator at least includes a curved section that at least partially follows the contour of the corresponding fan; wherein the radiator comprises a plurality of radiator fins arranged in a stacked manner relative to one another along the axial direction, and a gap is formed between at least one pair of adjacent radiator fins in a height direction perpendicular to the circumferential direction and the axial direction, the gap allowing airflow to flow from the circumferential outside of the radiator toward the circumferential inside of the radiator. According to the present disclosure, the heat exchange area of the radiator can be significantly increased within a limited space.

In some embodiments, the radiator is a liquid-cooled radiator, wherein each radiator fin defines a pipe suitable for liquid circulation.

In some embodiments, the radiator includes a liquid inlet port disposed at one end of the plurality of radiator fins and a liquid outlet port disposed at the opposite end of the plurality of fins, wherein the liquid inlet port includes an inlet header pipe connecting the plurality of radiator fins in parallel with each other, and the liquid outlet port includes an outlet header pipe connecting the plurality of radiator fins in parallel with each other.

In some embodiments, the cooling system further includes a pump, the pump being connected to the inlet header pipe or the outlet header pipe through a pipeline to circulate the liquid in the radiator fins.

In some embodiments, the radiator further at least includes a straight section connected to the curved section.

In some embodiments, the radiator is approximately C-shaped when viewed axially from the fan.

In some embodiments, the plurality of radiator fins includes a first group of radiator fins and a second group of radiator fins arranged adjacently in the circumferential direction, wherein one of the first group of radiator fins and the second group of radiator fins is located on a side radially adjacent to the fan, and the other of the first group of radiator fins and the second group of radiator fins is located on a side radially remote from the fan.

In some embodiments, the first group of radiator fins and the second group of radiator fins are fluidly connected in series, such that liquid flows out of the radiator sequentially through the first group of radiator fins and the second group of radiator fins.

In some embodiments, the cooling system further comprising a pipe connector interconnecting an outlet pipe of the first group of radiator fins and an inlet pipe of the second group of radiator fins.

In some embodiments, the first group of radiator fins and the second group of radiator fins are fluidly connected in parallel, such that liquid flows out of the radiator in parallel through the first group of radiator fins and the second group of radiator fins.

In some embodiments, the radiator further includes a pipe splitter interconnecting an inlet pipe of the first group of radiator fins and an inlet pipe of the second group of radiator fins, such that fluid from a main pipe is split through the pipe splitter to the inlet pipe of the first group of radiator fins and the inlet pipe of the second group of radiator fins; and the radiator further includes a pipe combiner interconnecting an outlet pipe of the first group of radiator fins and an outlet pipe of the second group of radiator fins, such that fluid from the outlet pipe of the first group of radiator fins and the outlet pipe of the second group of radiator fins is combined through the pipe combiner to the main fluid pipe.

In some embodiments, the cooling system further comprises a frame defining a receiving cavity, the at least one fan and the at least one radiator being received in the receiving cavity.

In some embodiments, the at least one fan includes a first fan and a second fan arranged side by side in a plane perpendicular to the axial direction, and the at least one radiator includes a first radiator for the first fan and a second radiator for the second fan.

In some embodiments, the cooling system further comprises a partition plate located between the first fan and the second fan to fluidly isolate the first fan and the second fan from each other.

In some embodiments, the first radiator and the second radiator each include a surrounding section and an opening section, and the first radiator and the second radiator are arranged opposite to each other at the opening sections.

A second aspect of the present disclosure provides a charging pile. The charging pile comprises: a power module; and the cooling system according to any one of the embodiments of the first aspect, configured to cool the power module.

### Brief Description of the Drawings

The above and other objects, features, and advantages of the embodiments of the present disclosure will become readily understood by reading the following detailed description with reference to the accompanying drawings. In the drawings, several embodiments of the present disclosure are illustrated by way of example and not limitation.
FIG. 1 shows a schematic view of the configuration of a charging pile according to an embodiment of the present disclosure.
FIG. 2 shows a schematic view of internal components of a cooling system for a charging pile according to an embodiment of the present disclosure.
FIG. 3 shows a schematic diagram of a cooling system for a charging pile according to an embodiment of the present disclosure, showing airflow paths.
FIG. 4 shows a perspective view of a radiator of a cooling system according to an embodiment of the present disclosure.
FIG. 5 shows a detailed partial view of a radiator of a cooling system according to an embodiment of the present disclosure.
FIG. 6 shows a perspective schematic view of a radiator of a cooling system and a fluid circulation circuit according to another embodiment of the present disclosure.
FIG. 7 shows a perspective schematic view of a radiator of a cooling system and a fluid circulation circuit according to yet another embodiment of the present disclosure.

### Detailed Description of Embodiments

Unless otherwise specified, corresponding numerals and symbols in different drawings generally refer to corresponding regions. The drawings are drawn to clearly illustrate the relevant aspects of the embodiments and are not necessarily drawn to scale. The edges of features depicted in the drawings do not necessarily indicate the termination of the feature ranges.

In the following description, various specific details are set forth in order to provide a thorough understanding of various examples of embodiments according to the description. Embodiments may be obtained without one or more specific details, or by using other methods, components, materials, etc. In other instances, well-known structures, materials, or operations are not shown or described in detail so as not to obscure aspects of the embodiments.

References to "one embodiment" or "one implementation" in the context of this specification are intended to indicate that a specific configuration, structure, or characteristic described with respect to that embodiment is included in at least one embodiment. Thus, phrases such as "in an embodiment", "in one embodiment", etc., which may appear in various aspects of this specification, do not necessarily refer to the same embodiment. Furthermore, the specific configurations, structures, or characteristics may be combined in any suitable manner in one or more embodiments.

In the present disclosure, directional terms such as "upper", "lower", "top side", "bottom side", "front", "rear" , "inner", and "outer" are defined relative to the orientation or position in which components are schematically placed in the drawings. It should be understood that these directional terms are relative concepts used for relative description and clarification, and are not intended to indicate or imply that the referred device or component must have a specific orientation, or be constructed and operated in a specific orientation. They may change accordingly based on the change in the orientation of the components placed in the drawings, and thus should not be construed as limiting the present application. The inventive concept according to the embodiments of the present disclosure will be described in detail below with reference to the accompanying drawings.

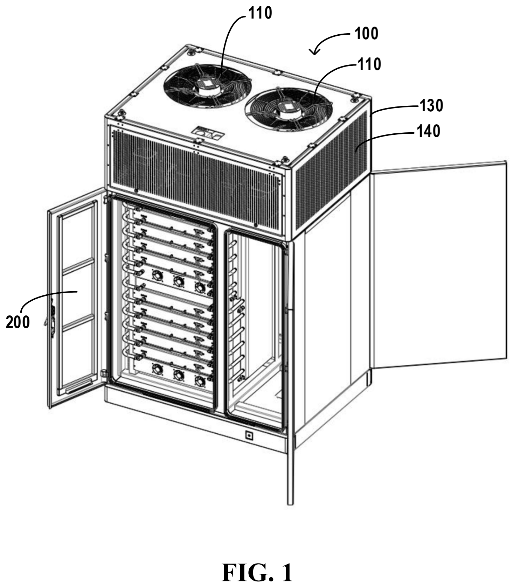

FIG. 1 shows a schematic view of the configuration of a charging pile according to an embodiment of the present disclosure. A charging pile is typically a standalone device and is installed upright in indoor or outdoor garages. A charging pile system includes a charging pile (also referred to as a charging pile main unit) and one or more terminal devices (not shown in the figure) electrically connected to the charging pile. The charging pile is generally in the form of a cabinet and may include a frame and a door mounted on the frame. FIG. 1 shows the door in an open state. One or more groups of power modules 200 are arranged inside the cabinet; the power modules 200 can, for example, convert alternating current (AC) into direct current (DC) and supply the DC to the terminal devices.

The terminal device includes one or more charging guns, which can be connected to the charging connector of an electric vehicle to charge the electric vehicle. During the operation of the charging pile, the power modules 200 generates a large amount of heat. If such heat is not discharged from the cabinet as soon as possible, it will affect the operation of the power modules 200 inside the cabinet and even damage the power equipment. To this end, the charging pile is further provided with a cooling system 100.

As shown in FIG. 1, the cooling system 100 may be arranged adjacent to the power modules 200. In the illustrated embodiment, the cooling system 100 is disposed above the power modules 200. The cooling system may be arranged in a receiving cavity enclosed by the frame 130. The main heat exchange components of the cooling system, such as fans, radiators, and the like, may be arranged in the receiving cavity. The outer periphery of the receiving cavity may be provided with air-permeable components 140 such as filter screens, shutters, or the like to allow airflow to pass through. It should be understood that the illustrated manner is merely exemplary. The cooling system may be arranged at other positions adjacent to the power modules, for example, on the side of the power modules 200.

Considering the limitations on the cabinet size of the charging pile, the space available for arranging the cooling system 100 is generally restricted. One of the technical problems that the present disclosure aims to solve is how to improve cooling efficiency within a relatively limited space. It should be understood that in the illustrated embodiment, a charging pile is used as an example of a heat source to illustrate the inventive concept according to the present disclosure, and it should also be understood that the inventive concept of the present disclosure can also be applied to the cooling of other heat sources.

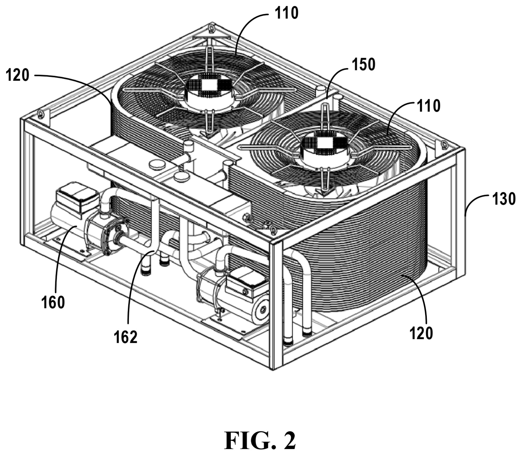

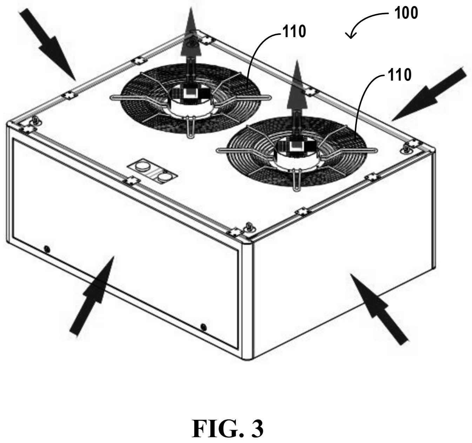

FIG. 2 shows a schematic view of internal components of a cooling system 100 for a charging pile according to an embodiment of the present disclosure. FIG. 3 shows a schematic view of a cooling system for a charging pile according to an embodiment of the present disclosure, in which airflow paths are shown. As shown in FIG. 2, the cooling system 100 includes one or more fans 110 and one or more radiators 120 arranged around the fans 110. By way of example, the fans may be axial flow fans. In the illustrated embodiment, two fans 110 and two radiators 120 are arranged in one charging cabinet. It should be understood that the number of fans and radiators may be other numbers.

As indicated by the arrows in FIG. 3, the fans 110 are configured to draw airflow from a radial outside during operation and discharge the drawn airflow in an axial direction. The axial direction may correspond to the direction communicating with the heat source. The radial outside of the fans corresponds to the external environment. Thus, the fans 110 can radially draw in ambient air as cold airflow, mix it with the axial airflow as hot airflow, and then discharge it together with the axial airflow to the external environment.

The radiator 120 is formed in a shape surrounding the fan 110. As shown in FIG. 2, the radiator 120 may include a curved section 125 shaped to at least partially follow the contour of the fan 110. Since the curved section 125 can follow the contour of the fan 110, the heat dissipation area of the radiator can be maximized. During the process of airflow entering the fan from the radial outside, the airflow will first come into contact with the radiator 120 surrounding the fan, and during this process, the airflow will exchange heat with the radiator 120. By increasing the area of the radiator surrounding the fan 110, the heat exchange efficiency can be significantly increased.

In some embodiments, as shown in FIG. 3, since the radiator 120 is formed in a shape surrounding the fan 110, this allows airflow to enter the cooling system from all four directions of the fan. This is also beneficial for improving heat dissipation efficiency. In some embodiments, as shown in FIG. 2, the two radiators 120 each include a surrounding section and an opening section, and the two radiators 120 are arranged opposite to each other at the opening sections. In some embodiments, the radiator 120 is, for example, approximately C-shaped. This arrangement allows radiators to be provided around almost all directions of the fan. In some embodiments (not shown), a single radiator may be disposed around a single fan. In this case, the radiator may be approximately annular.

In some embodiments, the cooling system 100 further includes a partition plate 150 located between the fans 110. The partition plate 150 can isolate the cooling systems formed by the two fans to prevent mutual interference. This allows the user to selectively shut down one fan without affecting the operation of adjacent systems, which is particularly suitable when the power modules 200 are not operating at full load.

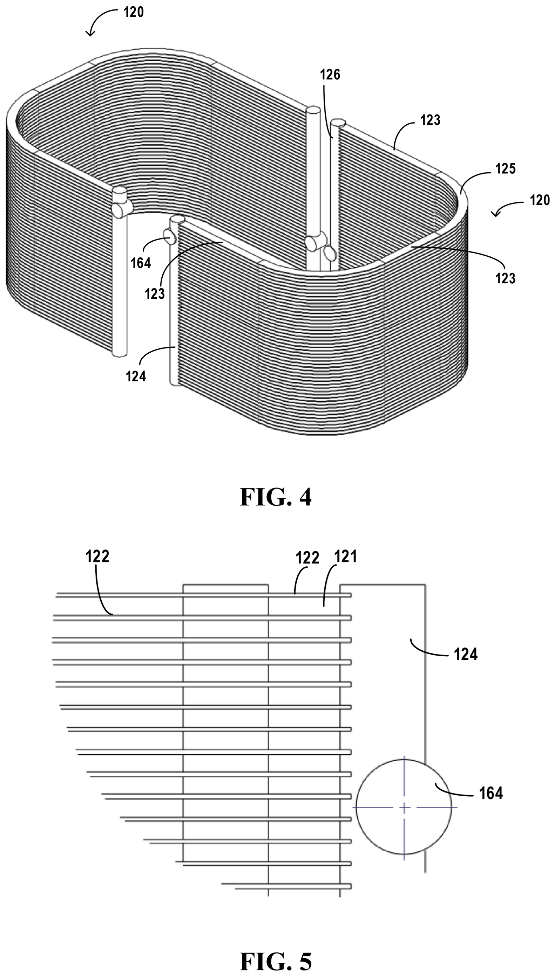

FIG. 4 shows a perspective view of a radiator of a cooling system according to an embodiment of the present disclosure. As shown in FIG. 4, the radiator 120 may include one or more curved sections 125 and one or more straight sections 123. The curved sections 125 and the straight sections are connected to each other to form a radiator surrounding the fan. In the illustrated embodiment, three straight sections 123 and two curved sections 125 are shown. It should be understood that the numbers of these straight sections 123 and curved sections 125 is merely exemplary and may be any other numbers. In some other embodiments (not shown), the radiator may be entirely composed of curved sections 125.

FIG. 5 shows a detailed partial view of a radiator of a cooling system according to an embodiment of the present disclosure. As shown in FIGS. 4 and 5, the radiator 120 comprises a plurality of radiator fins 122 arranged in a stacked manner relative to one another along the axial direction. A gap 121 is formed between a pair of adjacent radiator fins 122 in a height direction perpendicular to the circumferential direction and the axial direction. The gap 121 allows airflow to flow from the circumferential outside of the radiator 120 toward the circumferential inside of the radiator 120. By providing the gap 121, airflow can smoothly flow from the radial outside of the fan (corresponding to the circumferential outside of the radiator) to the radially inner side of the fan (corresponding to the circumferential inside of the radiator), during which the airflow exchanges heat with the radiator fins 122 of the radiator 120.

In some embodiments, the cooling system 100 is a fluid circulation cooling system. As shown in FIG. 2, in addition to fans and radiators, the cooling system further includes components such as a pump 160, a pipeline 162, and a water tank. The radiator may be a fluid circulation radiator. In this case, each radiator fin 122 defines a pipe suitable for liquid circulation. The liquid used for heat exchange can circulate in the pipes to further increase the heat exchange efficiency.

With further reference to FIGS. 4 and 5, the radiator 120 may include a liquid inlet port disposed at one end of the plurality of radiator fins 122 and a liquid outlet port disposed at the opposite end of the plurality of fins. At the liquid inlet port, an inlet header pipe 124 connecting the plurality of radiator fins 122 in parallel with each other may be provided, and at the liquid outlet port, an outlet header pipe 126 connecting the plurality of radiator fins 122 in parallel with each other may be provided. Thus, the cooling liquid can enter the radiator from the inlet header pipe 124, flow sequentially through each section of the radiator, and exit the radiator from the outlet header pipe 126. Pipe joints 164 may be provided at the inlet header pipe 124 and the outlet header pipe 126, and the pipe joints 164 may be connected to the pump 160 through a pipeline 162. When the pump 160 is in operation, it circulates the liquid within the radiator.

In some embodiments, the cooling system further includes a temperature sensor disposed within the pipeline, and the pump 160 is configured to operate based on the temperature sensed by the temperature sensor.

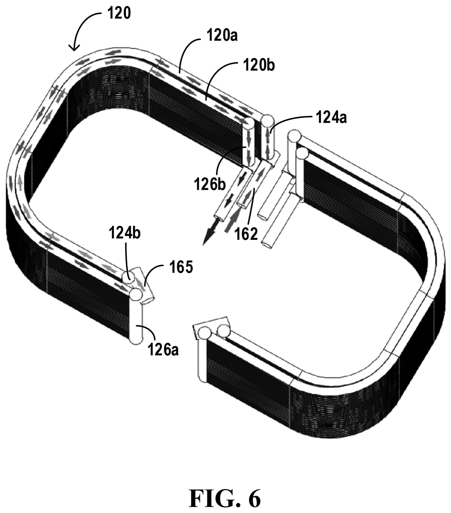

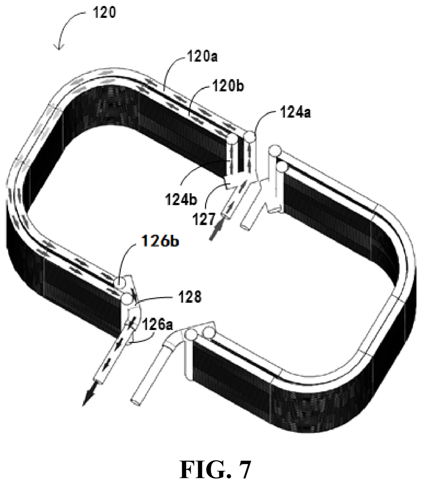

In some embodiments, the radiator may be formed in a multi-layer arrangement. This can further improve heat dissipation efficiency without requiring any additional modifications to the pump. FIG. 6 shows a perspective view of a radiator of a cooling system and a fluid circulation circuit according to another embodiment of the present disclosure. FIG. 7 shows a perspective view of a radiator of a cooling system and a fluid circulation circuit according to yet another embodiment of the present disclosure. FIGS. 6 and 7 show that the radiators are implemented in a double-layer arrangement. It should be understood that the radiators may also be implemented in a configuration of more than two layers.

In some embodiments, as shown in FIGS. 6 and 7, the plurality of radiator fins 122 of each radiator 120 includes a first group of radiator fins 120a and a second group of radiator fins 120b arranged adjacently in the circumferential direction. The first group of radiator fins 120a is located on the side radially remote from the fan, and the second group of radiator fins 120b is located on the side radially close to the fan. This double-layer arrangement can further enhance heat dissipation capacity within a limited space.

In some embodiments, as shown in FIG. 6, the first group of radiator fins 120a and the second group of radiator fins 120b are connected in series. Thus, as indicated by the arrows in FIG. 6, the liquid flows out of the radiator 120 sequentially through the first group of radiator fins 120a and the second group of radiator fins 120b. The radiator 120 may include a pipe connector 165 interconnecting the outlet pipe 126a of the first group of radiator fins 120a and the inlet pipe 124b of the second group of radiator fins 120b. Thus, the liquid flows sequentially through the first group of radiator fins 120a and the second group of radiator fins 120b.

In some embodiments, as shown in FIG. 7, the first group of radiator fins 120a and the second group of radiator fins 120b are connected in parallel. As indicated by the arrows in FIG. 7, the liquid flows out of the radiator 120 in parallel through the first group of radiator fins 120a and the second group of radiator fins 120b. The radiator may include a pipe splitter 127 interconnecting the inlet pipe 124a of the first group of radiator fins 120a and the inlet pipe 124b of the second group of radiator fins 120b. Fluid from the main pipe is split through the pipe splitter 127 to the inlet pipe 124a of the first group of radiator fins 120a and the inlet pipe 124a of the second group of radiator fins 120b. The radiator further includes a pipe combiner 128 interconnecting the outlet pipe 126a of the first group of radiator fins 120a and the outlet pipe 126b of the second group of radiator fins 120b, such that fluid from the outlet pipe 126a of the first group of radiator fins 120a and the outlet pipe 126b of the second group of radiator fins 120b is combined through the pipe combiner 128 to the main fluid pipe.

Based on the teachings provided in the foregoing description and in the associated drawings, many modifications and other embodiments of the present disclosure set forth herein will be appreciated by persons skilled in the relevant art of the present disclosure. Therefore, it is to be understood that the embodiments of the present disclosure are not limited to the specific embodiments disclosed, and that modifications and other embodiments are intended to be included within the scope of the present disclosure. Furthermore, while the foregoing description and associated drawings describe exemplary embodiments in the context of certain exemplary combinations of components and/or functions, it will be appreciated that different combinations of components and/or functions may be provided by alternative embodiments without departing from the scope of the present disclosure. In this regard, for example, other combinations of components and/or functions different from those explicitly described above are also contemplated to be within the scope of the present disclosure. Although specific terms are employed herein, they are used in a generic and descriptive sense only and are not intended to be limiting.

## Claims

1. A cooling system (100) comprising:
at least one fan (110) configured to draw airflow from a radial outside during operation and discharge the drawn airflow in an axial direction; and
at least one radiator (120), each radiator (120) being disposed to circumferentially surround a corresponding fan (110) of the at least one fan (110), wherein the radiator (120) at least includes a curved section (125) that at least partially follows the contour of the corresponding fan (110);
wherein the radiator (120) comprises a plurality of radiator fins (122) arranged in a stacked manner relative to one another along the axial direction, and a gap (121) is formed between at least one pair of adjacent radiator fins (122) in a height direction perpendicular to the circumferential direction and the axial direction, the gap (121) allowing airflow to flow from the circumferential outside of the radiator (120) toward the circumferential inside of the radiator (120).

2. The system according to claim 1, **characterized in that** the radiator (120) is a liquid-cooled radiator (120), wherein each radiator fin (122) defines a pipe suitable for liquid circulation.

3. The system according to claim 2, **characterized in that** the radiator (120) includes a liquid inlet port disposed at one end of the plurality of radiator fins (122) and a liquid outlet port disposed at the opposite end of the plurality of fins, wherein the liquid inlet port includes an inlet header pipe (124) connecting the plurality of radiator fins (122) in parallel with each other, and the liquid outlet port includes an outlet header pipe (126) connecting the plurality of radiator fins (122) in parallel with each other.

4. The system according to claim 3, **characterized in that** the cooling system further includes a pump (160), the pump (160) being connected to the inlet header pipe (124) or the outlet header pipe (126) through a pipeline (162) to circulate the liquid in the radiator fins (122).

5. The system according to any of claims 1 to 4, **characterized in that** the radiator (120) further at least includes a straight section connected to the curved section (125).

6. The system according to any of claims 1 to 5, **characterized in that** the radiator (120) is approximately C-shaped when viewed axially from the fan (110).

7. The system according to any one of claims 1-6, **characterized in that** the plurality of radiator fins (122) includes a first group of radiator fins (120a) and a second group of radiator fins (120b) arranged adjacently in the circumferential direction, wherein one of the first group of radiator fins (120a) and the second group of radiator fins (120b) is located on the side radially adjacent to the fan, and the other of the first group of radiator fins (120a) and the second group of radiator fins (120b) is located on the side radially remote from the fan.

8. The system according to claim 7, **characterized in that** the first group of radiator fins (120a) and the second group of radiator fins (120b) are fluidly connected in series, such that liquid flows out of the radiator (120) sequentially through the first group of radiator fins (120a) and the second group of radiator fins (120b).

9. The system according to claim 7 or 8, **characterized by** further comprising a pipe connector interconnecting an outlet pipe (126a) of the first group of radiator fins (120a) and an inlet pipe (124b) of the second group of radiator fins (120b).

10. The system according to any of claims 7, 8 or 9, **characterized in that** the first group of radiator fins (120a) and the second group of radiator fins (120b) are fluidly connected in parallel, such that liquid flows out of the radiator (120) in parallel through the first group of radiator fins (120a) and the second group of radiator fins (120b).

11. The system according to any of claims 7 to 10, **characterized in that** the radiator further includes a pipe splitter (127) interconnecting an inlet pipe (124a) of the first group of radiator fins (120a) and an inlet pipe (124b) of the second group of radiator fins (120b), such that fluid from a main pipe is split through the pipe splitter (127) to the inlet pipe (124a) of the first group of radiator fins (120a) and the inlet pipe (124b) of the second group of radiator fins (120b); and
the radiator further includes a pipe combiner (128) interconnecting an outlet pipe (126a) of the first group of radiator fins (120a) and an outlet pipe (126b) of the second group of radiator fins (120b), such that fluid from the outlet pipe (126a) of the first group of radiator fins (120a) and the outlet pipe (126b) of the second group of radiator fins (120b) is combined through the pipe combiner (128) to the main fluid pipe.

12. The system according to any one of claims 1-11, **characterized by** further comprising a frame (130) defining a receiving cavity, the at least one fan (110) and the at least one radiator (120) being received in the receiving cavity.

13. The system according to any one of claims 1-12, **characterized in that** the at least one fan (110) includes a first fan and a second fan arranged side by side in a plane perpendicular to the axial direction, and the at least one radiator (120) includes a first radiator (120) for the first fan and a second radiator (120) for the second fan, the system preferably further comprising a partition plate (150) located between the first fan and the second fan to fluidly isolate the first fan and the second fan from each other.

14. The system according to claim 13, **characterized in that** the first radiator (120) and the second radiator (120) each include a surrounding section and an opening section, and the first radiator (120) and the second radiator (120) are arranged opposite to each other at the opening sections.

15. A charging pile comprising:
a power module (200); and
the cooling system (100) according to any one of claims 1-14, configured to cool the power module (200).
